# EUROPÄISCHE PATENTSCHRIFT

(11) **EP 2 054 953 B1**
(45) Veröffentlichungstag und Bekanntmachung des Hinweises auf die Patenterteilung: **31.08.2011**
(21) Anmeldenummer: 07817705.2
(22) Anmeldetag: 19.10.2007
(51) Int. Cl.: H01L 41/107

(54) **PIEZOTRANSFORMATOR**
PIEZOELECTRIC TRANSFORMER
PIÉZOTRANSFORMATEUR

(30) Priorität: 23.10.2006 DE 102006049919
(43) Veröffentlichungstag der Anmeldung: 06.05.2009
(73) Patentinhaber: Epcos AG, 81669 München (DE)
(72) Erfinder: HOFFMANN, Christian, 8530 Deutschlandsberg (AT); KARTASHEV, Igor, Dr., 8530 Deutschlandsberg (AT)
(74) Vertreter: Epping - Hermann - Fischer
(86) Internationale Anmeldenummer: PCT/DE2007/001871
(87) Internationale Veröffentlichungsnummer: WO 2008/049394

(56) Entgegenhaltungen:
- JP-A- 4 167 504
- JP-A- 4 338 685
- JP-A- 7 176 804
- JP-A- 2000 353 833
- US-A- 5 278 471
- US-B1- 6 346 763

## Beschreibung

Gattungsgemäße Piezotransformatoren sind aus US 6,346,763 B1 und insbesondere aus JP 04-338685A bekannt.

US 6,346,763 B1 zeigt einen Piezotransformator, bei dem ein Funktionsteil einen anderen ringförmig umgibt, wobei die Außenelektroden beider Funktionsteile in einem geringeren Abstand voneinander angeordnet sind als von der Innenelektrode des jeweils anderen Funktiontsteils.

JP 04-338685 A zeigt einen Piezotransformator, bei dem ein Funktionsteil einen anderen ringförmig umgibt und dessen Elektroden als Innenelektroden ausgebildet sind, von denen einige auf gleicher Höhe angeordnet sind. Zusätzlich sind an der Oberfläche des Transformator körpers noch elektrische Außenanschlüsse angeordnet, die über leitfähige Durchkontaktierungen an die jeweiligen Innenelektroden angeschlossen sind.

Eine zu lösende Aufgabe besteht darin, einen Piezotransformator mit einer höheren Durchschlagfestigkeit anzugeben. Diese Aufgabe wird durch einen Piezotransformator gemäß Anspruch 1 gelöst.

Es wird ein Piezotransformator mit einem Körper angegeben, der einen ersten und einen zweiten Funktionsteil umfasst. Jeder Funktionsteil weist Außenelektroden auf, die an der Oberfläche des Körpers angeordnet sind. Der erste Teil ist beispielsweise ein Ausgangsteil und der zweite Teil ein Eingangsteil des Transformators, oder umgekehrt. Die Funktionsteile sind z. B. mittels eines Isolierteils mechanisch miteinander verbunden.

An den Eingangsteil wird eine elektrische Wechselspannung angelegt, die dort aufgrund eines Piezoeffekts mechanische Deformationen bewirkt. Die Deformationen rufen einen Potentialunterschied zwischen den Elektroden des Ausgangsteils hervor. Vom Ausgangsteil wird eine Ausgangsspannung abgegriffen, die sich ggf. von der Eingangsspannung um einen vom Aufbau des Transformators abhängigen Transformationsfaktor unterscheidet.

Der zweite Funktionsteil weist im Körper angeordnete Innenelektroden auf, die an Außenelektroden dieses Teils angeschlossen sind. Eine erste Außenelektrode des ersten Funktionsteils ist parallel zu den Innenelektroden des zweiten Funktionsteils angeordnet. Der Mindestabstand zwischen der ersten Außenelektrode des ersten Funktionsteils und der jeweiligen Außenelektrode des zweiten Funktionsteils ist größer gewählt als der Abstand zwischen der ersten Außenelektrode des ersten Funktionsteils und der jeweiligen ihr zugewandten endständigen Innenelektrode des zweiten Funktionsteils.

Der Abstand zwischen den Außenelektroden der beiden Funktionsteile ist also besonders groß gewählt, wodurch auch eine für einen elektrischen Durchschlag ausschlaggebende Kriechstrecke an der Oberfläche gegenüber einem Mindestabstand zwischen leitfähigen Strukturen der beiden Transformatorteile vergrößert ist. Somit gelingt es in Verbindung mit weiteren noch nachstehend genannten Maßnahmen, eine hohe Durchschlagfestigkeit bei einer kleinen Baugröße des Transformators zu erzielen.

Der Körper umfasst eine Vielzahl von dielektrischen Schichten, die vorzugsweise Keramik enthalten. Die dielektrischen Schichten weisen piezoelektrische Eigenschaften auf. Eine Innenelektrode ist (im zweiten Funktionsteil) zwischen zwei dielektrischen Schichten angeordnet. Im ersten Funktionsteil bilden aufeinander folgende dielektrische Schichten einen dielektrischen Schichtverbund, der zwischen den Außenelektroden dieses Funktionsteils angeordnet ist. Dieser Schichtverbund enthält erfindungsgemäß keine Innenelektroden.

Der erste Funktionsteil ist weiterhin erfindungsgemäß vom zweiten Funktionsteil ringförmig umschlossen.

In beiden Funktionsteilen sind akustische Schwingungen in einer Lateralebene, also parallel zu den Elektroden der Funktionsteile, anregbar.

Die erste Außenelektrode des ersten Funktionsteils ist in einer Variante auf einer ersten Hauptfläche des Körpers angeordnet. Der erste Funktionsteil weist eine zweite Außenelektrode auf, die vorzugsweise auf einer zweiten Hauptfläche des Körpers angeordnet ist. Der Mindestabstand zwischen der zweiten Außenelektrode des ersten Funktionsteils und der jeweiligen Außenelektrode des zweiten Funktionsteils ist vorzugsweise ebenfalls größer gewählt als der Abstand zwischen der zweiten Außenelektrode des ersten Funktionsteils und einer ihr zugewandten endständigen Innenelektrode des zweiten Funktionsteils.

Die Außenelektroden des zweiten Funktionsteils sind vorzugsweise zumindest teilweise auf Seitenflächen des Körpers angeordnet. Sie sind vorzugsweise auf die Seitenflächen des Körpers beschränkt. In diesem Fall ist die Entfernung zwischen der ersten Außenelektrode des ersten Funktionsteils und der jeweiligen Außenelektrode des zweiten Funktionsteils besonders groß.

Alternativ kann mindestens eine der Außenelektroden des zweiten Funktionsteils mindestens einen Bereich aufweisen, der über die Kanten der Seitenflächen des Körpers hinaus geht, d. h. im Randbereich einer Hauptfläche des Körpers angeordnet ist.

Die Funktionsteile haben in einer Variante eine gemeinsame Außenelektrode, die zumindest teilweise auf einer zweiten Hauptfläche des Körpers angeordnet ist.

Die Innenelektroden des zweiten Funktionsteils weisen in einer vorteilhaften Variante zumindest in einem - der ersten Außenelektrode des ersten Funktionsteils gegenüber liegenden - Bereich eine Aussparung oder Öffnung auf. Zumindest eine Außenelektrode des ersten Funktionsteils überlappt in einer Variante mit keiner der Innenelektroden des zweiten Funktionsteils.

Die der ersten Außenelektrode des ersten Teils zugewandte endständige Innenelektrode des zweiten Funktionsteils kann als eine Masseelektrode vorgesehen sein. Die endständige Innenelektrode kann alternativ eine Signalelektrode sein.

Die Innenelektroden des zweiten Funktionsteils umfassen erste und zweite Innenelektroden, wobei beispielsweise zweite Innenelektroden mit Masse verbunden sind. Die zweiten Innenelektroden weisen jeweils eine Öffnung auf, die vorzugsweise kleiner ist als eine ihr gegenüber liegende Öffnung der ersten Innenelektroden. Die Öffnungen der ersten und zweiten Innenelektroden können alternativ gleich gewählt sein.

Der Körper umfasst des Weiteren erfindungsgemäß eine elektrisch isolierende endständige Schicht, auf der die erste Außenelektrode des ersten Funktionsteils angeordnet ist. Die endständige Schicht überdeckt erfindungsgemäß endständige Elektroden des zweiten Funktionsteils, die der ersten Außenelektrode des ersten Funktionsteils zugewandt sind.

Die endständige Schicht ist in einer Variante dünner ausgebildet als eine Schicht, die zwischen zwei aufeinander folgenden Innenelektroden des zweiten Funktionsteils unterschiedlicher Polarität angeordnet ist.

Die endständige Schicht weist in einer Variante piezoelektrische Eigenschaften auf. Diese Schicht kann in diesem Fall zur Vergrößerung eines für die Transformation der elektromechanischen Energie relevanten aktiven Volumens des ersten Funktionsteils benutzt werden.

Eine elektrisch isolierende, aber nicht piezoelektrische endständige Schicht kommt auch in Betracht. Das Material der endständigen Schicht ist dabei vom Material der übrigen dielektrischen Schichten des Körpers unterschiedlich. Beispielsweise ist eine glashaltige oder SiO₂-haltige endständige Schicht vorteilhaft.

Das Material der endständigen Schicht kann alternativ gleich wie bei den übrigen dielektrischen Schichten gewählt sein.

Der Körper kann im Prinzip einen beliebigen, beispielsweise runden, ovalen, quadratischen, recht- oder mehreckigen Querschnitt aufweisen.

Der Piezotransformator wird nun anhand von schematischen und nicht maßstabgetreuen Figuren erläutert. Es zeigen:
Figur 1 verschiedene Ansichten eines ersten erfindungsgemäßen Transformators mit einer endständigen Schicht, auf der die Außenelektrode des ersten Funktionsteils angeordnet ist;
Figur 2 im Querschnitt einen weiteren erfindungsgemäßen Transformator, dessen Funktionsteile eine gemeinsame Außenelektrode aufweisen;
Figur 3 im Querschnitt einen weiteren erfindungsgemäßen Transformator, bei dem die Außenelektroden des zweiten Funktionsteils auf die Seitenflächen beschränkt sind;
Figur 4 im Querschnitt einen nicht-erfindungsgemäßen Transformator, bei dem die Außenelektroden des ersten Funktionsteils mit einer durch die jeweilige endständige Schicht überdeckte Innenelektrode leitend verbunden ist.

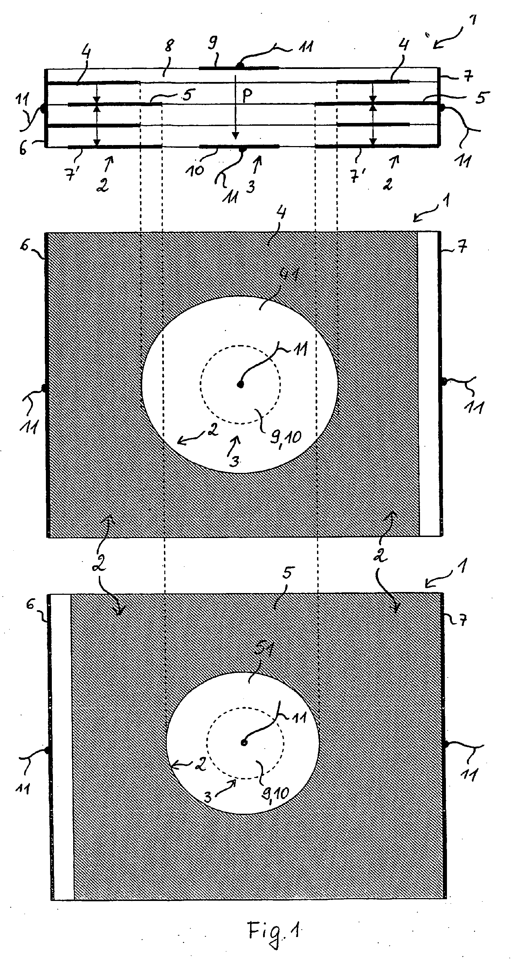

Figur 1 zeigt einen Piezotransformator im Querschnitt (oben) sowie eine Draufsicht auf eine erste und zweite Metallisierungsebene (in der Mitte und unten).

Der Piezotransformator weist einen Körper 1 auf, der einen im Querschnitt kreisförmigen ersten Funktionsteil 3 und einen zweiten Funktionsteil 2 umfasst. Der zweite Funktionsteil 2 umgibt ringförmig den ersten Funktionsteil 1.

Der erste Funktionsteil 3 weist Außenelektroden 9, 10 und der zweite Funktionsteil 2 Außenelektroden 6, 7 auf. Die erste Außenelektrode 9 des ersten Funktionsteils 3 ist auf der oberen Hauptfläche und die zweite Außenelektrode 10 des ersten Funktionsteils 3 auf der unteren Hauptfläche angeordnet. Die Außenelektroden 6, 7 sind auf einander gegenüber liegenden Seitenflächen des Körpers 1 angeordnet. Die Außenelektrode 7 weist einen auf der unteren Hauptfläche angeordneten Bereich 7' auf, der in Fig. 1 im Wesentlichen gleich ausgebildet ist wie die zweiten Innenelektroden 5 des zweiten Funktionsteils 2.

Die Außenelektroden 6, 7, 9, 10 sind jeweils mit einem Anschlussdraht 11 verbunden. Die Anschlussdrähte können angelötet oder an die Außenelektroden angepresst sein. Andere Verbindungsarten sind auch möglich.

Der Körper umfasst mehrere piezoelektrische Schichten, zwischen denen erste und zweite Metallisierungsebenen abwechselnd angeordnet sind. Die Polarisationsrichtung P der jeweiligen piezoelektrischen Schicht oder des Verbunds der piezoelektrischen Schichten ist mit Pfeilen gekennzeichnet.

In der jeweiligen ersten Metallisierungsebene ist eine erste Innenelektrode 4 des zweiten Funktionsteils und in der jeweiligen zweiten Metallisierungsebene eine zweite Innenelektrode 5 des zweiten Funktionsteils 2 ausgebildet. Die Innenelektroden 4, 5 haben unterschiedliche Polarität.

Die ersten Innenelektroden 4 sind jeweils mit der ersten Außenelektrode 6 des zweiten Funktionsteils leitend verbunden und von der zweiten Außenelektrode 7 dieses Funktionsteils beabstandet. Die zweiten Innenelektroden 5 sind jeweils mit der zweiten Außenelektrode 7 des zweiten Funktionsteils leitend verbunden und von der ersten Außenelektrode 6 dieses Funktionsteils beabstandet.

Der Abstand zwischen der oberen Außenelektrode 9 des ersten Funktionsteils und der jeweiligen Außenelektrode 6, 7 des zweiten Funktionsteils ist größer als derjenige zwischen der Außenelektrode 9 und der obersten Innenelektrode 4 des zweiten Funktionsteils.

Jede erste Innenelektrode 4 weist eine Öffnung 41 und jede zweite Innenelektrode 5 eine (in der Variante gemäß der Figur 1 etwas kleinere) Öffnung 51 auf.

Der Körper 1 umfasst eine endständige dielektrische Schicht 8, die die endständige (oberste) Innenelektrode 4 des zweiten Funktionsteils 4 vollständig überdeckt. Die Schicht 8 hat eine kleinere Dicke als die jeweilige piezoelektrische Schicht, die zwischen zwei Innenelektroden 4, 5 angeordnet ist.

Die erste Außenelektrode 9 des ersten Funktionsteils 3 ist auf der Oberseite der endständigen Schicht 8 angeordnet.

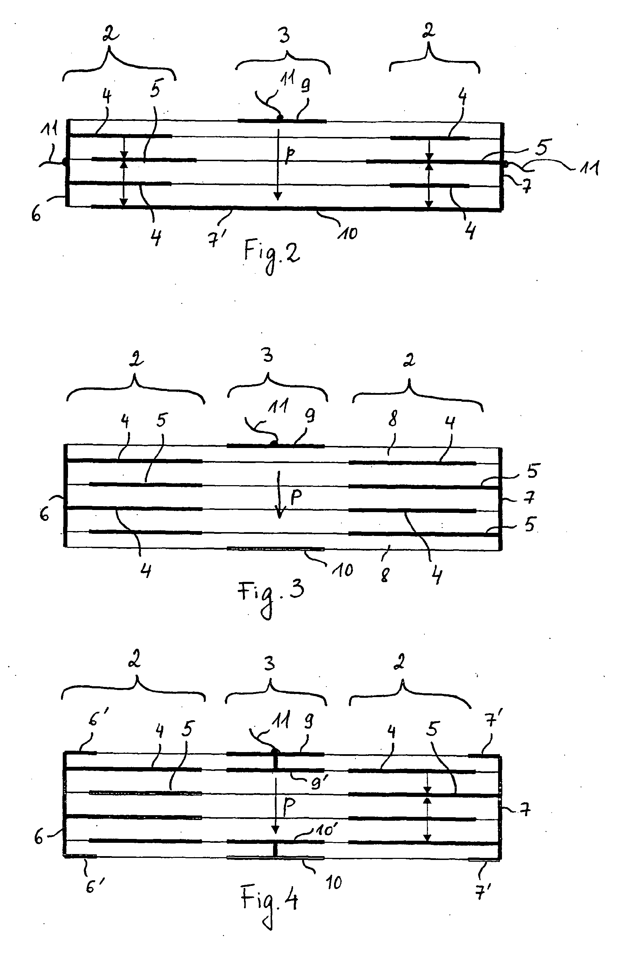

In den Figuren 2 bis 4 sind weitere mögliche Ausgestaltungen des angegebenen Piezotransformators erläutert.

In der Variante gemäß der Figur 2 haben beide Funktionsteile 2, 3 des Transformators eine gemeinsame Außenelektrode 10, die auf der unteren Hauptfläche des Körpers 1 angeordnet ist. In diesem Fall ist eine elektrische Verbindung zwischen den Außenelektroden 7 und 10 der beiden Funktionsteile auf der Oberfläche des Körpers 1 realisiert. Möglich ist es auch, die ursprünglich nicht miteinander verbundenen Außenelektroden 7, 10 (siehe Figur 1) extern, d. h. außerhalb des Körpers 1, leitend miteinander zu verbinden.

In der Variante gemäß der Figur 3 ist eine weitere endständige dielektrische Schicht 8 vorgesehen, die die unterste Innenelektrode 5 des zweiten Funktionsteils 2 überdeckt. Die zweite Außenelektrode 10 des ersten Funktionsteils 3 ist auf der Unterseite der unteren endständigen Schicht 8 angeordnet. Der Abstand zwischen der unteren Außenelektrode 10 des ersten Funktionsteils und der jeweiligen Außenelektrode 6, 7 des zweiten Funktionsteils ist größer als derjenige zwischen der Außenelektrode 10 und der untersten Innenelektrode 5 des zweiten Funktionsteils. Für den Abstand zwischen der oberen Außenelektrode 9 des ersten Funktionsteils und der jeweiligen Außenelektrode 6, 7 des zweiten Funktionsteils gilt die Beschreibung der Figur 1.

In der nicht-erfindungsgemäßen Variante gemäß der Figur 4 wird im Gegensatz zu den erfindungsgemäßen Ausführungsformen gemäß den Figuren 1 bis 3 die Elektrode des ersten Funktionsteils nicht durch die Außenelektrode gebildet, sondern statt dessen ist im ersten Funktionsteil 3 eine mit der ersten Außenelektrode 9 leitend verbundene Innenelektrode 9' und eine mit der zweiten Außenelektrode 10 leitend verbundene Innenelektrode 10' vorgesehen. Zum Zwecke der elektrischen Verbindung der Außenelektrode 9, 10 und der Innenelektrode 9', 10' ist die jeweilige endständige Schicht 8 durchkontaktiert.

Die hauptsächlich auf der Seitenfläche des Körpers 1 angeordnete Außenelektrode 6, 7 weist im Randbereich der oberen und unteren Hauptfläche angeordnete Bereiche 6', 7' auf.

### Bezugszeichenliste

- 1: Körper
- 2: zweiter Funktionsteil
- 3: erster Funktionsteil
- 4: erste Innenelektrode
- 41: Öffnung
- 5: zweite Innenelektrode
- 51: Öffnung
- 6, 7: Außenelektroden des zweiten Funktionsteils 2
- 6', 7': an der Hauptfläche des Körpers 1 liegende Bereiche der Außenelektroden 6, 7
- 8: endständige Schicht
- 9, 10: Außenelektroden des ersten Funktionsteils 3
- 9', 10': Innenelektroden des ersten Funktionsteils 3
- 11: Anschlussdraht
- P: Polarisationsrichtung der piezoelektrischen Schicht

## Patentansprüche

1. Piezotransformator
- mit einem Körper (1), der einen ersten Funktionsteil (3) und einen zweiten Funktionsteil (2) umfasst, wobei der zweite Funktionsteil (2) den ersten Funktionsteil (3) ringförmig umgibt,
- wobei jeder Funktionsteil (2, 3) Außenelektroden (6, 7, 9, 10) aufweist, die an der Oberfläche des Körpers (1) angeordnet sind,
- wobei der erste Funktionsteil (3) Keine Innenelektroden aufweist wohingegen der zweite Funktionsteil (3) im Körper (1) angeordnete Innenelektroden (4, 5) aufweist, die an die Außenelektroden (6, 7) des zweiten Funktionsteils angeschlossen sind,
- wobei eine erste Außenelektrode (9) des ersten Funktionsteils parallel zu den Innenelektroden (4, 5) des zweiten Funktionsteils angeordnet ist,
- wobei der Körper (1) eine endständige dielektrische Schicht (8) umfasst, auf der die erste Außenelektrode (9) des ersten Funktionsteils (3) angeordnet ist, wobei die endständige dielektrische Schicht (8) endständige Innenelektroden (4, 5) des zweiten Funktionsteils (2), die der ersten Außenelektrode (9) des ersten Funktionsteils (3) zugewandt sind, überdeckt, und
- wobei der Mindestabstand zwischen der ersten Außenelektrode (9) des ersten Funktionsteils (3) und der jeweiligen Außenelektrode (6, 7) des zweiten Funktionsteils (2) größer gewählt ist als der Abstand zwischen der ersten Außenelektrode (9) des ersten Funktionsteils (3) und der jeweiligen ihr zugewandten endständigen Innenelektrode (4, 5) des zweiten Funktionsteils (2).

2. Piezotransformator nach Anspruch 1,
- wobei die erste Außenelektrode (9) des ersten Funktionsteils (3) auf einer ersten Hauptfläche des Körpers (1) angeordnet ist.

3. Piezotransformator nach Anspruch 1 oder 2,
- wobei in beiden Funktionsteilen (2, 3) Schwingungen in einer Lateralebene anregbar sind.

4. Piezotransformator nach einem der Ansprüche 1 bis 3,
- wobei die Außenelektroden (6, 7) des zweiten Funktionsteils (2) auf Seitenflächen des Körpers (1) angeordnet sind.

5. Piezotransformator nach Anspruch 4,
- wobei die Außenelektroden (6, 7) des zweiten Funktionsteils (2) auf die Seitenflächen des Körpers (1) beschränkt sind.

6. Piezotransformator nach Anspruch 4,
- wobei mindestens eine der Außenelektroden (6, 7) des zweiten Funktionsteils (2) mindestens einen Bereich aufweist, der über die Kanten der Seitenflächen des Körpers (1) hinaus geht.

7. Piezotransformator nach einem der Ansprüche 1 bis 6,
- wobei beide Funktionsteile (2, 3) eine gemeinsame Außenelektrode (7', 10) haben, die zumindest teilweise auf einer zweiten Hauptfläche des Körpers (1) angeordnet ist.

8. Piezotransformator nach einem der Ansprüche 1 bis 6,
- wobei der erste Funktionsteil (3) eine zweite Außenelektrode (10) aufweist, die auf einer zweiten Hauptfläche des Körpers (1) angeordnet ist,
- wobei der Mindestabstand zwischen der zweiten Außenelektrode (10) des ersten Funktionsteils (3) und der jeweiligen Außenelektrode (6, 7) des zweiten Funktionsteils (2) größer gewählt ist als der Abstand zwischen der zweiten Außenelektrode (10) des ersten Funktionsteils (3) und einer ihr zugewandten endständigen Innenelektrode (4, 5) des zweiten Funktionsteils (2).

9. Piezotransformator nach einem der Ansprüche 1 bis 8,
- wobei die Innenelektroden (4, 5) zumindest in einem der ersten Außenelektrode (9) des ersten Funktionsteils (3) gegenüber liegenden Bereich eine Aussparung aufweisen.

10. Piezotransformator nach einem der Ansprüche 1 bis 9,
- wobei die endständige Schicht (8) dünner ausgebildet ist als eine Schicht, die zwischen zwei aufeinander folgenden Innenelektroden (4, 5) unterschiedlicher Polarität angeordnet ist.

11. Piezotransformator nach einem der Ansprüche 1 bis 10,
- wobei sich das Material der endständigen Schicht (8) vom Material der übrigen dielektrischen Schichten des Körpers (1) unterscheidet.

## Claims

1. Piezotransformer
- comprising a body (1) comprising a first functional part (3) and a second functional part (2), wherein the second functional part (2) surrounds the first functional part (3) in a ring-shaped fashion,
- wherein each functional part (2, 3) has external electrodes (6, 7, 9, 10) arranged at the surface of the body (1),
- wherein the first functional part (3) has no internal electrodes, whereas the second functional part (3) has internal electrodes (4, 5) arranged in the body (1), said internal electrodes being connected to the external electrodes (6, 7) of the second functional part,
- wherein a first external electrode (9) of the first functional part is arranged parallel to the internal electrodes (4, 5) of the second functional part,
- wherein the body (1) comprises a terminally situated dielectric layer (8), on which the first external electrode (9) of the first functional part (3) is arranged, wherein the terminally situated dielectric layer (8) covers terminally situated internal electrodes (4, 5) of the second functional part (2) which face the first external electrode (9) of the first functional part (3),
- wherein the minimum distance between the first external electrode (9) of the first functional part (3) and the respective external electrode (6, 7) of the second functional part (2) is chosen to be greater than the distance between the first external electrode (9) of the first functional part (3) and the respective terminally situated internal electrode (4, 5) of the second functional part (2) that faces it.

2. Piezotransformer according to Claim 1,
- wherein the first external electrode (9) of the first functional part (3) is arranged on a first main area of the body (1).

3. Piezotransformer according to Claim 1 or 2,
- wherein in both functional parts (2, 3) oscillations can be excited in a lateral plane.

4. Piezotransformer according to any of Claims 1 to 3,
- wherein the external electrodes (6, 7) of the second functional part (2) are arranged on side areas of the body (1).

5. Piezotransformer according to Claim 4,
- wherein the external electrodes (6, 7) of the second functional part (2) are restricted to the side areas of the body (1).

6. Piezotransformer according to Claim 4,
- wherein at least one of the external electrodes (6, 7) of the second functional part (2) has at least one region which goes beyond the edges of the side areas of the body (1).

7. Piezotransformer according to any of Claims 1 to 6,
- wherein both functional parts (2, 3) have a common external electrode (7', 10) which is at least partly arranged on a second main area of the body (1).

8. Piezotransformer according to any of Claims 1 to 6,
- wherein the first functional part (3) has a second external electrode (10), which is arranged on a second main area of the body (1),
- wherein the minimum distance between the second external electrode (10) of the first functional part (3) and the respective external electrode (6, 7) of the second functional part (2) is chosen to be greater than the distance between the second external electrode (10) of the first functional part (3) and a terminally situated internal electrode (4, 5) of the second functional part (2) which faces it.

9. Piezotransformer according to any of Claims 1 to 8,
- wherein the internal electrodes (4, 5) have a cutout at least in a region lying opposite the first external electrode (9) of the first functional part (3).

10. Piezotransformer according to any of Claims 1 to 9,
- wherein the terminally situated layer (8) is embodied such that it is thinner than a layer arranged between two successive internal electrodes (4, 5) of differing polarity.

11. Piezotransformer according to any of Claims 1 to 10,
- wherein the material of the terminally situated layer (8) differs from the material of the remaining dielectric layers of the body (1).

## Revendications

1. Piézotransformateur comprenant :
un corps (1) qui comporte une première partie fonctionnelle (3) et une deuxième partie fonctionnelle (2), la deuxième partie fonctionnelle (2) entourant en anneau la première partie fonctionnelle (3),
chaque partie fonctionnelle (2, 3) présentant des électrodes extérieures (6, 7, 9, 10) disposées à la surface du corps (1),
la première partie fonctionnelle (3) ne présentant pas d'électrodes intérieures, mais en revanche la deuxième partie fonctionnelle (3) présentant des électrodes intérieures (4, 5) disposés dans le corps (1) et raccordées aux électrodes extérieures (6, 7) de la deuxième partie fonctionnelle,
une première électrode extérieure (9) de la première partie fonctionnelle étant disposée parallèlement aux électrodes intérieures (4, 5) de la deuxième partie fonctionnelle,
le corps (1) comportant une couche diélectrique terminale (8) sur laquelle la première électrode extérieure (9) de la première partie fonctionnelle (3) est disposée, la couche diélectrique terminale (8) couvrant des électrodes intérieures terminales (4, 5) de la deuxième partie fonctionnelle (2) qui sont tournées vers la première électrode extérieure (9) de la première partie fonctionnelle (3),
la distance minimale entre la première électrode extérieure (9) de la première partie fonctionnelle (3) et chaque électrode extérieure (6, 7) de la deuxième partie fonctionnelle (2) étant plus grande que la distance entre la première électrode extérieure (9) de la première partie fonctionnelle (3) et l'électrode intérieure terminale (4, 5) correspondante, tournée vers elle, de la deuxième partie fonctionnelle (2).

2. Piézotransformateur selon la revendication 1, dans lequel la première électrode extérieure (9) de la première partie fonctionnelle (3) est disposée sur une première surface principale du corps (1).

3. Piézotransformateur selon les revendications 1 ou 2, dans lequel des oscillations peuvent être excitées dans un plan latéral dans les deux parties fonctionnelles (2, 3).

4. Piézotransformateur selon l'une des revendications 1 à 3, dans lequel les électrodes extérieures (6, 7) de la deuxième partie fonctionnelle (2) sont disposées sur des surfaces latérales du corps (1).

5. Piézotransformateur selon la revendication 4, dans lequel les électrodes extérieures (6, 7) de la deuxième partie fonctionnelle (2) sont restreintes aux surfaces latérales du corps (1).

6. Piézotransformateur selon la revendication 4, dans lequel au moins l'une des électrodes extérieures (6, 7) de la deuxième partie fonctionnelle (2) présente au moins une partie qui déborde au-delà des bords des surfaces latérales du corps (1).

7. Piézotransformateur selon l'une des revendications 1 à 6, dans lequel les deux parties fonctionnelles (2, 3) présentent une électrode extérieure commune (7', 10) qui est disposée au moins en partie sur une deuxième surface principale du corps (1).

8. Piézotransformateur selon l'une des revendications 1 à 6, dans lequel la première partie fonctionnelle (3) présente une deuxième électrode extérieure (10) disposée sur une deuxième surface principale du corps (1), la distance minimale entre la deuxième électrode extérieure (10) de la première partie fonctionnelle (3) et chaque électrode extérieure (6, 7) de la deuxième partie fonctionnelle (2) étant plus grande que la distance entre la deuxième électrode extérieure (10) de la première partie fonctionnelle (3) et une électrode intérieure terminale (4, 5), tournée vers elle, de la deuxième partie fonctionnelle (2).

9. Piézotransformateur selon l'une des revendications 1 à 8, dans lequel les électrodes intérieures (4, 5) présentent une découpe au moins dans une partie située face à la première électrode extérieure (9) de la première partie fonctionnelle (3).

10. Piézotransformateur selon l'une des revendications 1 à 9, dans lequel la couche terminale (8) est plus mince qu'une couche disposée entre deux électrodes intérieures (4, 5) successives de polarités différentes.

11. Piézotransformateur selon l'une des revendications 1 à 10, dans lequel le matériau de la couche terminale (8) est différent du matériau des autres couches diélectriques du corps (1).
